# EUROPÄISCHE PATENTSCHRIFT

(11) **EP 1 352 410 B1**
(45) Veröffentlichungstag und Bekanntmachung des Hinweises auf die Patenterteilung: **02.06.2004**
(21) Anmeldenummer: 01273278.0
(22) Anmeldetag: 23.11.2001
(51) Int. Cl.: H01J 37/153

(54) **ELEKTROSTATISCHER KORREKTOR**
ELECTROSTATIC CORRECTOR
CORRECTEUR ELECTROSTATIQUE

(30) Priorität: 20.01.2001 DE 10102527
(43) Veröffentlichungstag der Anmeldung: 15.10.2003
(73) Patentinhaber: Ceos Corrected Electron Optical Systems GmbH, 69126 Heidelberg (DE)
(72) Erfinder: ROSE, Harald, 64287 Darmstadt (DE); UHLEMANN, Stephan, 69115 Heidelberg (DE); WEISSBÄCKER, Christoph, 64807 Dieburg (DE)
(74) Vertreter: Pöhner, Wilfried, Dr.
(86) Internationale Anmeldenummer: PCT/DE2001/004446
(87) Internationale Veröffentlichungsnummer: WO 2002/058101

(56) Entgegenhaltungen:
- EP-A- 0 451 370
- DE-A- 4 204 512
- DE-A- 19 926 927

## Beschreibung

Die Erfindung bezieht sich einen elektrostatischen Korrektor mit gerader optischer Achse zur Beseitigung des Farbfehters von Teilchenlinsen mit zwei Korrekturstücken, die entlang der optischen Achse hinter einander angeordnet sind und jeweils elektrische Quadrupolfelder und überlagerte Rundlinsenfelder aufweisen, wobei in einem Korrekturstück das von einem Achsenpunkt erzeugte astigmatische Zwischenbild des einen Schnitts und im anderen Korrekturstück das dazu senkrechte astigmatische Zwischenbild des anderen Schnitts zu liegen kommt.

Teilchenoptische Systeme, insbesondere Elektronenmikroskope, sind zur Abbildung atomarer Strukturen geeignet. Dabei gibt es jedoch eine physikalische Grenze für das Auflösungsvermögen eines optischen Systems, welche durch die Beugung bestimmt wird. Sie bewirkt, daß zwei getrennte Objektpunkte durch das optische System nur dann noch als getrennte Punkte wiedergegeben werden, wenn ihr Abstand den Minimalwert d = 0,6Δλ/α nicht unterschreitet, wobei λ die Wellenlänge und a den maximalen Öffnungswinkel des optischen Systems darstellt. Will man Körper mit kleinsten Abmessungen abbilden, muß diese Grenze d möglichst kleine Werte annehmen, d.h. die Wellenlänge λ der abbildenden Strahlen muß klein und der Öffnungswinkel α groß gewählt werden. Durch den Übergang vom Licht- zum Elektronenmikroskop erreicht man einen Auflösungsgewinn etwa um den Faktor 10³ ,da die Wellenlänge um einen Faktor von etwa 10⁻⁵ kleiner wird, während der maximale Öffnungswinkel um etwa 10⁻² abnimmt.

Diese Verbesserung der Auflösung ist jedoch noch nicht ausreichend, um atomare Dimensionen mit dem Elektronenmikroskop auflösen zu können. Zur weiteren Steigerung des Auflösungsvermögens ist es daher notwendig, Systeme mit großem Öffnungswinkel α einzusetzen. Dabei handelt man sich jedoch das Problem ein, daß die vom Öffnungswinkel abhängigen Bildfehler zur Wirkung kommen, die ihrerseits die Auflösung herabsetzen. Zur Korrektur dieser Bildfehler, insbesondere der chromatischen Aberration (Farbfehler) und der sphärischen Aberration (Öffnungsfehler) sind in der Vergangenheit erhebliche Anstrengungen untemommen worden. Die bisher besten Erfolge hat man dabei mit optischen Systemen erreicht, in denen anstelle rotationssymmetrischer Felder Multipole, insbesondere Quadrupolen und Oktopole, verwendet werden.

Nach dem Stand der Technik ist ein aus elektrischen und magnetischen Multipolen aufgebauter Korrektor (Nucl. Instr. methods A363 (1995), S 316) bekannt, mit dem es gelungen ist, in einem Niederspannungsrasterelektronenmikroskop die sphärische und chromatische Aberration vollständig zu korrigieren. Das mit dieser Anordnung erreichte Auflösungsvermögen lag bei einem Wert von 2 nm, wobei die angewandte Elektronenenergie 1 kV betragen hatte. Die Verwendung von magnetischen Multipolen führt jedoch dazu, daß aufgrund der magnetische Remanenz die Einstellung der Felder in nachteiliger Weise nur schwer reproduzierbar ist.

Ein Korrektor zur Beseitigung des Farbfehlers in beiden Schnitten mit rein elektrischen Feldern wird in der DE 199 26 927 vorgestellt. Der hier vorgeschlagene Korrektor weist zwei Korrekturstücke auf, die entlang der optischen Achse hinter einander angeordnet sind und jeweils elektrische Quadrupolfelder und überlagerte Rundlinsenfelder erzeugen. Der wesentliche Vorteil dieses Korrektors gegenüber dem vorbenannten liegt darin, daß sich die zur Korrektur erforderlichen Felder präzise und vor allem reproduzierbar einstellen lassen. In der Praxis hat sich als Nachteil dieser Ausführung jedoch herausgestellt, daß eine hohe Auflösung nur in extrem achsennahen Bereichen erreicht wird, so daß die nutzbare Bildfeldgröße auf insgesamt lediglich etwa 20 Bildpunkte beschränkt ist.

Vor diesem Hintergrund hat sich die Erfindung die Aufgabe gestellt, einen Korrektor zur Beseitigung des Farbfehlers in Teilchenlinsen zu schaffen, der einerseits rein elektrostatische Felder nutzt und andererseits ein um ein Vielfaches größeres Bildfeld bietet.

Gelöst wird diese Aufgabe erfindungsgemäß dadurch, daß
- zwei Korrektureinheiten vorgesehen sind
- beide Korrektureinheiten
   - apparativ gleich ausgebildet sind,
   - entlang der optischen Achse hinter einander
   - und um 90 Grad um die optische Achse gegeneinander verdreht angeordnet sind.
- jede Korrektureinheit
   - eines der aus wenigstens drei Quadrupolen gebildeten Korrekturstücke aufweist,
      - an dessen Ein- und Ausgangsseite jeweils zwei weitere elektrostatische Quadropole angeordnet sind
   - und die axialen Bahnen teleskopisch in einer 1:1-Abbildung abbildet.

Der Korrektor gemäß vorliegender Erfindung baut auf einem an sich bekannten elektrostatischen Korrektor mit zwei Korrekturstücken auf, die entlang der optischen Achse hinter einander angeordnet sind. Jedes dieser Korrekturstücke weist drei elektrische Quadrupolfelder und überlagerte Rundlinsenfelder auf, wobei die Felder des ersten und zweiten Korrekturstücks relativ zueinander um einen Winkel von 90 Grad um die optisches Achse gedreht sind. Die Arbeitsweise jenes Korrektors ist so gewählt, daß in einem Korrekturstück das von einem Achsenpunkt erzeugte astigmatische Zwischenbild des einen Schnitts und im anderen Korrekturstück das dazu senkrechte astigmatische Zwischenbild des anderen Schnitts zu liegen kommt.

Bei vorliegender Erfindung sind die Korrekturstücke jeweils innerhalb einer Korrektureinheit angeordnet, an deren Ein- und Ausgangsseite jeweils zwei weitere Qudropolfelder vorgesehen sind. Beide Korrektureinheiten sind einander baugleich ausgeführt und entlang der optischen Achse hintereinander angeordnet, wobei die zweite Einheit um 90 Grad verdreht gegenüber der ersten angeordnet ist. Die von einem Objektpunkt ausgehenden Strahlen durchlaufen nach Durchtritt durch das Objektiv damit der Reihe nach folgende Felder:
- erste Korrektureinheit:
   - an der Eingangsseite zunächst die Felder zweier hintereinander liegender Quadrupole,
   - anschließend drei aufeinanderfolgende Quadrupole des ersten Korekturstücks mit überlagertem Rundlinsenfeld
   - an der Ausgangsseite ebenfalls wieder zwei Quadrupolfelder
- zweite Korrektureinheit:
   - eingangsseitig die Felder zweier hintereinander liegender Quadrupole,
   - anschließend drei aufeinanderfolgende Quadrupole des zweiten Korekturstücks mit überlagertem Rundlinsenfeld
   - ausgangsseitig ebenfalls wieder zwei Quadrupolfelder
wobei die Felder in der zweiten Korrektureinheit aufgrund der Drehung dieser Einheit um die optische Achse gegenüber den Feldern der ersten Korrektureinheit um 90 Grad gedreht sind.

Der Strahlengang der axialen Strahlen im Korrektor sieht dabei folgendermaßen aus:

Die von einem Objektpunkt auf der optischen Achse ausgehenden Strahlen werden durch das Objektiv in Richtung zum Bildpunkt hin abgelenkt. Bei Eintritt dieser Strahlen in den Korrektor bewirken die beiden eingangsseitig angeordneten Quadrupole, daß die im x- bzw. y-Schnitt verlaufenden axialen Bahnen in unterschiedliche Richtungen abgelenkt werden. Das Teilchenbündel wird hierdurch in einem Schnitt, beispielsweise im x-Schnitt fokussiert, während es im anderen Schnitt, dem y-Schnitt, aufgeweitet wird, so daß ein astigmatisches Zwischenbild entsteht Durch geeignete Wahl der Stärke der elektrischen Potentiale an den beiden Quadrupolen kommt dieses Zwischenbild in der Mitte des Korrekturstücks zu liegen. Ausdrücklich umfaßt sind auch jene Fälle, in denen zwei astigmatische Zwischenbilder im gleichen Schnitt und in Richtung er optischen Achse kurz hintereinander zu liegen kommen. Anstelle eines astigmatischen Zwischenbildes entstehen somit zwei eng benachbarte Zwischenbilder. Die Felder des Korrekturstücks greifen daher im wesentlichen nur an den aufgeweiteten Strahlen des y-Schnittes an, wodurch deren Bahnverlauf eine erhebliche Beeinflussung und einen negativen Beitrag zum Farbfehler erfährt. Im x-Schnitt dagegen entfalten die Korrekturfelder nur eine geringe Wirkung, da die axiale Bahn nahe der optischen Achse verläuft und der Beitrag der Korrekturfelder zum Farbfehler daher gering ausfällt. Beim Durchlaufen der am Ausgang der ersten Korrektureinheit angeordneten zwei weiteren Quadrupole wird der Astigmatismus des Bündels wieder aufgehoben und dessen Rotationssymmetrie wieder hergestellt. Die Strahlen in beiden Schnitten verlassen die erste Korrektureinheit daher ohne Aufspaltung.

Beim Durchlaufen der zweiten, baugleich ausgeführten Korrektureinheit folgen die abbildenden Strahlen den gleichen Bahnen und erfahren dabei prinzipiell die gleiche Beeinflussung wie in der ersten Einheit. Aufgrund der Drehung der zweiten relativ zur ersten Einheit werden in dieser Korrektureinheit jedoch die Strahlen des x-Schnittes aufgeweitet, während die Strahlen des y-Schnittes fokussiert werden. Dementsprechend greifen die Korrekturfelder im Korrekturstück dieser Einheit nur an den Strahlen im x-Schnitt an, während die im y-Schnitt liegenden Strahlen dagegen nur eine geringe Einwirkung erfahren. Nach Durchtritt durch die beiden ausgangsseitig angeordneten Quadrupolfelder verläßt das Teilchenbündel auch die zweite Korrektureinheit als rotationssymmetrisches Bündel.

Die vorliegende Anordnung bewirkt somit eine Änderung des Farbfehlers des einen Schnittes in der ersten Korrektureinheit, des Farbfehlers des zweiten Schnittes in der zweiten Korrektureinheit und in Summe damit des Farbfehlers des gesamten Strahlenbündels. Bei entsprechender Wahl der Potentiale an den Quadrupolelementen der beiden Korrekturstücke läßt sich erreichen, daß sich die Farbfehler von Objektiv und Korrektureinheiten kompensieren und somit das gesamte aus Objektivlinse und Korrektor gebildete System frei von Farbfehlem ist.

Von außen betrachtet, verhalten sich die beiden Korrektureinheiten gemäß vorliegender Erfindung jeweils wie dicke Rundlinsen, welche die axialen Bahnen jeweils teleskopisch in einer 1:1-Abbildung abbilden. Aufgrund der baugleichen Ausführung der beiden Korrektureinheiten sind die Felder an den eingangsseitig einander entsprechenden und den ausgangsseitig einander entsprechenden Mulipolelementen der beiden Korrektureinheiten jeweils gleich groß. Hieraus folgt in vorteilhafter Weise die Einstellung gleicher Potentiale an jeweils einander entsprechenden Quadrupolen der beiden Korrektureinheiten. Insbesondere ergeben sich hierdurch auch gleiche Beiträge zum Farbfehler bzw. Änderungen des Farbfehlers in beiden Schnitten. Eine unterschiedliche Einstellung der Korrekturfelder in beiden Schnitten, wie bei bekannten Korrektoren, entfällt damit.

Der entscheiden Vorteil des erfindungsgemäßen Korrektors liegt jedoch in seiner hohen Auflösung, der hieraus folgenden wesentlich gesteigerten Bildfeldgröße und einer repoduzierbare Einstellung der Korrekturfeldstärken.

Eine bevorzugte Weiterbildung des erfindungsgemäßen elektrostatischen Korrektors weist Korrekturstücke auf, die jeweils in der Mitte der Korrektureinheiten angeordnet sind, wobei Aufbau und Felder der Korrektureinheiten bezüglich der zur optischen Achse senkrecht liegenden Mittelebene des Korrekturstücks spiegelsymmetrisch ausgebildet sind. Aus der genannten Spiegelsymmetrie folgt, daß Ein- und Ausgangsseite der Korrektureinheiten hinsichtlich ihres Aufbaus und ihrer Felder spiegelsymmetrisch zu einander sind. Ebenso folgt bei dem vorgegebenen baugleichen Aufbau und der um 90 Grad gegen einander verdrehten Anordnung der beiden Korrektureinheiten, daß auch die Felder der beiden Korrektureinheiten bezüglich der Ebene punktsymmetrisch sind, die mittig zwischen ihnen liegt und senkrecht zur optische Achse ausgerichtet ist.

Diese Doppelsymmetrie hat weitreichende Auswirkungen auf Größe und Art der Bildfehler innerhalb des Korrektors. Primär führt sie dazu, daß
- die axialen Bahnen zur Mitte des Korrekturstücks spiegelsymmetrisch verlaufen
- die Feldbahnen (außeraxialen Bahnen) zur Mitte des Korrekturstücks punktsymmetrisch verlaufen
- die axialen Bahnen in der Mittelebene zwischen beiden Korrektureinheiten hinsichtlich des x-/y-Schnitts ihre Rollen vertauschen
- an den (insgesamt vier) Quadrupolen, welche jeweils an den Eingangsund Ausgangsseiten der Korrektureinheiten angeordnet sind, dem Betrage nach gleiche Potentiale anliegen
- an den (insgesamt vier) Quadrupolen, die jeweils zwischen Eingangs- bzw. Ausgangsseite der Korektureinheiten und den Korrekturstücken angeordnet sind, dem Betrage nach gleiche Potentiale anliegen
- an den insgesamt vier beiderseits der Mittelebene der Korrekturstücke liegenden Quadrupole dem Betrage nach gleiche Potentiale anliegen.

Als Folge des symmetrischen/antisymmetrischen Verlaufs der Bahnen und der Felder gestaltet sich die analytische Berechnung der Bildfehlerintegrale wesentlich einfacher als bei bekannten Korrektoren. Die Vereinfachung besteht zum einen darin, daß die Integrale eine sehr übersichtliche Form annehmen und dadurch zu einem leichteren Verständnis des Korrektors bei unterschiedlichen Einstellungen führen. Zum anderen werden zahlreiche Fehlerintegrale zu Null, was bedeutet, daß die diesen Integralen entsprechenden Bildfehler in der vorgeschlagenen Anordnung gar nicht erst auftreten. So werden aufgrund der Symmetrie zwischen den Korrektureinheiten die Kombinationsfehler zwischen diesen Einheiten eliminiert. Desweiteren verschwinden alle außeraxialen Fehler, die von ungeraden Potenzen des Achseriabstandes abhängen. Die vorteilhafte Folge hiervon ist, daß die Auflösung des teilchenoptischen Systems auch außerhalb des achsennahen Bereichs essentiell verbessert wird. Bei Anwendung des erfindungsgemäßen Korrektors in einem Elektronenmikroskop äußert sich diese Verbesserung in einer nutzbare Bildfeldgröße, die etwa 1000 Bildpunkte umfaßt.

Die dargelegte Symmetrie führt auch zu einer wesentlichen Vereinfachung bei der Einstellung der zur Korrektur erforderlichen Felder. Durch die Vorgabe gleicher Potentiale an den verschiedenen Quadrupolelementen des Korrektors wird die an sich gegebene Vielfalt der Einstellmöglichkeiten eines Korrektors erheblich reduziert, die Durchführung der Korrektur wird hierdurch wesentlich vereinfacht. Eine vorteilhafte Folge der eingeschränkten Zahl an Parametern ist auch eine Verminderung der zur Spannungsversorgung notwendigen Geräte. Wie die Praxis gezeigt hat, erfordert der Korrektor gemäß vorliegender Erfindung aufgrund seiner hohen Symmetrie auch eine wesentlich geringere mechanische Fertigungsgenauigkeit, die Fertigungskosten des vorliegenden Korrektors liegen damit wesentlich niedriger als die von bekannten Korrektoren.

Der vorgeschlagene Korrektor ist neben einer Korrektur der chromatischen Aberration auch zur Korrektur der sphärischen Aberration geeignet Hierzu werden Oktupolfelder eingesetzt, d.h. Felder mit einer in azimutaler Richtung vierzählig ausgebildeten Symmetrie. Bei einer bevorzugten Ausführungsform des Korrektors sind drei derartige Felder erzeugende Oktupole vorgesehen, die jeweils in der Mittelebene der Korrekturstücke und in der Ebene, die in der Mitte zwischen beiden Korrektureinheiten liegt, angeordnet. Durch eine entsprechende Vorgabe der an den Oktupolen anliegenden elektrischen Potentiale läßt sich erreichen, daß sich die Öffnungsfehler von Objektiv und Korrektureinheiten kompensieren und somit das aus Objektivlinse und Korrektor gebildete System frei von sphärischer Aberration ist.

Nach einem Merkmal der Erfindung können die Oktupolfelder auch den Quadrupolfeldem überlagert werden. Bei vorliegendem Korrektor wird dies dahingehend genutzt, daß die zur Korrektur des Öffnungsfehlers eingesetzten Oktupolfelder den Feldern der innerhalb der Korrekturstücke angeordneten Quadrupolen überlagert sind. Ebenso ist bei einer Weiterbildung der Erfindung den an der Eingangs- und Ausgangsseite der Korrektureinheiten liegenden Quadrupolen jeweils ein Oktupolfeld überlagert. Diese Ausgestaltung ermöglicht es, auch eine Korrektur der Bildfeldwölbung durchzuführen.

Bei einer bevorzugten Ausführungsform des erfindungsgemäßen Korrektors werden Multipolelemente eingesetzt, die sowohl Quadrupolfelder als auch Oktupolfelder erzeugen. Damit wird einerseits die Übersichtlichkeit des Korrektors verbessert, andererseits werden die Kosten zu dessen Herstellung wesentlich gesenkt.

Weitere Einzelheiten, Merkmale und Vorteile der Erfindung lassen sich dem nachfolgenden Teil der Beschreibung entnehmen. In diesem Teil werden der Strahlengang und die Funktion des erfindungsgemäßen Korrektors anhand einer beigefügten Zeichnung näher erläutert. Die Figur zeigt in einer stark vereinfachten Darstellung einen Längsschnitt durch einen Korrektor.

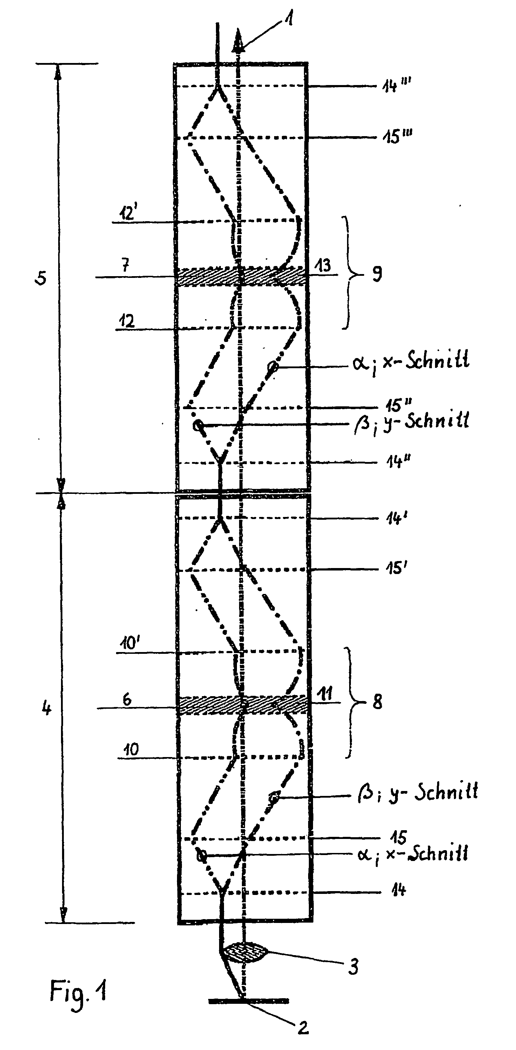

In der Figur 1 ist die optische Achse der Anordnung durch das Bezugszeichen 1 gekennzeichnet. Der Strahlengang durch den Korrektor wird anhand der paraxialen Fundamentalbahnen α und β dargestellt, die von einem auf der Achse liegenden Objektpunkt 2 ausgehen und durch die mit einem Farbfehler behaftete Objektivlinse 3 abgelenkt werden. Der Korrektor besteht in seinem grundsätzlichen Aufbau aus zwei baugleich ausgeführten Korrektureinheiten 4 und 5, die bezüglich ihrer Mittelebenen 6 und 7 spiegelsymmetrisch ausgebildet sind und um 90 Grad um die optische Achse gegeneinander verdreht sind. In der Mitte der Korrektureinheiten ist je ein Korrekturstück 8 und 9 vorgesehen, die ihrerseits aus je drei Quadrupolen 10, 11,10' bzw. 12, 13, 12' aufgebaut sind. Aufgrund der Spiegelsymmetrie sind die Quadrupole 10, 10' und 12, 12' einander baugleich und erzeugen dementsprechend gleiche Felder. An den Ein- und Ausgangsseiten der Korrektureinheit sind jeweils zwei weitere Quadrupole 14, 15, 14', 15', 14", 15", 14''', 15''' vorgesehen. Die Kennzeichnung durch gleiche Ziffern soll dabei andeuten, daß diese Quadrupole ebenfalls einander gleich ausgebildet sind.

Bei Eintritt der Strahlen in den Korrektor bewirken die beiden eingangsseitig angeordneten Quadrupole 14,15, daß die im x- bzw. y-Schnitt verlaufenden axialen Bahnen α und β in unterschiedliche Richtungen abgelenkt werden. Das Teilchenbündel wird hierdurch in einem Schnitt, beispielsweise im x-Schnitt fokussiert, während es im anderen Schnitt, dem y-Schnitt, aufgeweitet wird, so daß ein astigmatisches Zwischenbild entsteht. Durch geeignete Wahl der Stärke der elektrischen Potentiale an den beiden Quadrupolen 14, 15 kommt dieses Zwischenbild in der Mitte, bei mehreren astigmatischen Zwischenbildern im selben Schnitt symmetrisch zur Mitte des Korrekturstücks 8 zu liegen. Dieses Korrekturstück bewirkt eine Änderung und bei geeigneter Wahl der Quadrupolfeldstärken eine Beseitigung des Farbfehlers im y-Schnitt, d.h. dem Schnitt, in welchem die achsenferne β-Bahn verläuft. Im x-Schnitt dagegen entfalten die Korrekturfelder nur eine geringe Wirkung, da die α-Bahn nahe der optischen Achse verläuft und der Beitrag der Korrekturfelder zum Farbfehler daher gering ausfällt. Die am Ausgang der ersten Korrektureinheit angeordneten zwei Quadrupole 14',15' dienen dazu, die Rotationssymmetrie des Strahlenbündels wieder herzustellen.

Beim Durchlaufen der zweiten, baugleich ausgeführten Korrektureinheit 5 erfährt das Teilchenbündel prinzipiell die gleichen Beeinflussungen wie in der ersten Korrektureinheit. So führen die beiden Quadrupole 14", 15" zu einer Aufspaltung von α- und β-Bahn und die Qudrupole 12,13,12' des Korrekturstücks 9 zu einer Farbfehlerkorrektur. Aufgrund der Drehung der zweiten 5 relativ zur ersten Korrektureinheit 4 greifen die Felder des Korrekturstücks 9 jedoch an der im x-Schnitt verlaufenden α-Bahn an und bewirken daher eine Korrektur des Farbfehlers in diesem Schnitt. Nach Durchtritt durch die beiden ausgangsseitig angeordneten Quadrupolfelder 14"', 15"' verläßt das Teilchenbündel auch die zweite Korrektureinheit als rotationssysmmetrisches Bündel.

Die vorliegende Anordnung bewirkt somit eine Änderung bzw. Beseitigung des Farbfehlers je eines Schnittes in je einer Korrektureinheit und in Summe damit des Farbfehlers des gesamten Strahlenbündels.

## Patentansprüche

1. Elektrostatischer Korrektor mit gerader optischer Achse zur Beseitigung des Farbfehlers von Teilchenlinsen mit zwei Korrekturstücken, die entlang der optischen Achse hinter einander angeordnet sind und jeweils elektrische Quadrupolfelder und überlagerte Rundlinsenfelder aufweisen, wobei in einem Korrekturstück das von einem Achsenpunkt erzeugte astigmatische Zwischenbild des einen Schnitts und im anderen Korrekturstück das dazu senkrechte astigmatische Zwischenbild des anderen Schnitts zu liegen kommt, **dadurch gekennzeichnet, daß**
- zwei Korrektureinheiten vorgesehen
- beide Korrektureinheiten
- apparativ gleich ausgebildet sind,
- entlang der optischen Achse hinter einander
- und um 90 Grad um die optische Achse gegeneinander verdreht angeordnet sind,
- jede Korrektureinheit
- eines der aus wenigstens drei elektrostatischen Quadrupolen gebildeten Korrekturstücke aufweist,
- an dessen Ein- und Ausgangsseite jeweils zwei weitere elektrostatische Quadropole angeordnet sind
- und die axialen Bahnen teleskopisch in einer 1:1-Abbildung abbildet.

2. Elektrostatischer Korrektor nach Anspruch 1, **dadurch gekennzeichnet, daß** das Korrekturstück in der Mitte der Korrektureinheit angeordnet ist, und der Aufbau und/oder die Felder der Korrektureinheit bezüglich der zur optischen Achse senkrecht liegenden Mittelebene des Korrekturstücks spiegelsymmetrisch ausgebildet sind

3. Elektrostatischer Korrektor nach Anspruch 1 oder 2, **dadurch gekennzeichnet, daß** die Felder der beiden Korrektureinheiten bezüglich der Ebene, die in der Mitte zwischen beiden Korrektureinheiten und senkrecht zur optischen Achse liegt, punktsymmetrisch ausgebildet sind.

4. Elektrostatischer Korrektor nach einem der Ansprüche 1 - 3, **dadurch gekennzeichnet, daß** in der Mittelebene der Korrekturstücke und in der Ebene, die in der Mitte zwischen beiden Korrektureinheiten liegt, je ein Oktupol angeordnet ist.

5. Elektrostatischer Korrektor nach einem der Ansprüche 1 - 4, **dadurch gekennzeichnet, daß** ein Oktupolfeld einem Quadrupolfeld des Korrekturstücks überlagert ist.

6. Elektrostatischer Korrektor nach Anspruch 5, **dadurch gekennzeichnet, daß** die Überlagerung der Felder in wenigstens einem Quadrupol der Korrekturstücke und/oder wenigstens einem der an den Ein- und Ausgangsseiten der Korrektureinheiten angeordneten Quadrupole stattfindet.

7. Elektrostatischer Korrektor nach einem der vorangehenden Ansprüche, **dadurch gekennzeichnet, daß** dasselbe Multipolelement sowohl ein Quadropol- als auch ein Oktopolfeld erzeugt.

## Claims

1. Electrostatic corrector comprising a rectilinear optical axis for eliminating the chromatic aberration of particle lenses comprising two corrective parts, which are arranged one behind the other along the optical axis and have in each case electrical quadrupole fields and superimposed circular lens fields, the astigmatic intermediate image of one cross-section that is created by an axis point lying in one part of the corrector and the astigmatic intermediate image of the other cross-section, which is perpendicular to said first cross-section, lying in the other part of the corrector, **characterised that**.
- two corrector units are provided
- both corrector units being designed so as to be
- of identical technical design
- and arranged one behind the other along the optical axis
- and rotated through 90 degrees about the optical axis
- each corrector unit
- having one of the corrective parts formed from at least three quadrupoles
- at the input and output side of which two further electrostatic quadrupoles are arranged in each case
- and the axial paths are represented telescopically with a 1:1 representation.

2. Electrostatic corrector according to claim 1, **characterised in that** the corrector part is arranged in the centre of the corrective unit, the construction and/or the fields of the corrective units being designed so as to lie mirror symmetrically to the centre plane, lying perpendicular to the optical axis, of the corrective part.

3. Electrostatic corrector according to claim 1 or 2, **characterised in that** the fields of the two corrective units are point symmetrical with respect to the plane that lies symmetrically between the two corrective units and perpendicular to the optical axis.

4. Electrostatic corrector according to one of claims 1 to 3, **characterised in that** one octopole in each case is arranged in the centre plane of the corrective parts and in the plane which lies in the centre between the two corrective units.

5. Electrostatic corrector according to one of claims 1 to 4, **characterised in that** an octopole field is superimposed on a quadrupole field of the corrective part.

6. Electrostatic corrector according to claim 5, **characterised in that** the superimposition of the fields takes place in at least one quadrupole of the corrective parts and/or in at least one of the quadrupoles arranged at the input and output sides of the corrective units..

7. Electrostatic corrector according to one of the preceding claims, **characterised in that** one and the same multipole element generates both a quadrupole field and an octopole field..

## Revendications

1. Correcteur électrostatique à axe optique droit destiné à éliminer l'aberration chromatique des lentilles pour faisceaux de particules, comprenant deux zones de correction placées l'une après l'autre le long de l'axe optique et renfermant respectivement des champs quadripolaires et des champs superposés des lentilles sphériques, l'image astigmatique intermédiaire de l'une des coupes, générée par un point de l'axe, se trouvant dans la première zone de correction, et l'image astigmatique intermédiaire de l'autre coupe, perpendiculaire à la première, se trouvant dans la deuxième zone de correction,
**caractérisé en ce que**
- le dispositif comporte deux dispositifs de correction
- les deux dispositifs de correction
- sont identiques du point de vue matériel,
- sont placés l'un après l'autre le long de l'axe optique, et
- sont décalés de 90 degrés l'un par rapport à l'autre autour de l'axe optique,
- chaque dispositif de correction
- renferme une des zones de correction formées d'au moins trois quadripôles électrostatiques,
- cette zone de correction comportant deux autres quadripôles électrostatiques respectivement placés au niveau de l'entrée et au niveau de la sortie,
- et fournit une image à l'échelle 1/1 des orbites axiaux avec trajectoires télescopiques.

2. Correcteur électrostatique selon la revendication 1, **caractérisé en ce que** la zone de correction se trouve au centre du dispositif de correction et **en ce que** la construction et/ou les champs du dispositif de correction présentent une symétrie spéculaire par rapport au plan médian de la zone de correction, perpendiculaire à l'axe optique.

3. Correcteur électrostatique selon la revendication 1 ou 2, **caractérisé en ce que** les champs des deux dispositifs de correction présentent une symétrie ponctuelle par rapport au plan situé au centre entre les deux dispositifs de correction, perpendiculaire à l'axe optique.

4. Correcteur électrostatique selon l'une des revendications 1 à 3, **caractérisé en ce que** un octopôle se trouve respectivement dans le plan médian des zones de correction et dans le plan situé au centre entre les deux dispositifs de correction.

5. Correcteur électrostatique selon l'une des revendications 1 à 4, **caractérisé en ce que** un champ octopolaire est superposé au champ quadripolaire de la zone de correction.

6. Correcteur électrostatique selon la revendication 5, **caractérisé en ce que** la superposition des champs a lieu dans au moins un quadripôle des zones de correction et/ou dans au moins un des quadripôles situés au niveau de l'entrée et de la sortie des dispositifs de correction.

7. Correcteur électrostatique selon l'une des revendications précédentes, **caractérisé en ce que** le même élément multipolaire crée un champ quadripolaire et un champ octopolaire.
